# EUROPÄISCHE PATENTSCHRIFT

(11) **EP 3 262 758 B1**
(45) Veröffentlichungstag und Bekanntmachung des Hinweises auf die Patenterteilung: **13.01.2021**
(21) Anmeldenummer: 15709090.3
(22) Anmeldetag: 26.02.2015
(51) Int. Cl.: H03K 17/969

(54) **BEDIENVORRICHTUNG, INSBESONDERE FÜR EIN ELEKTRONISCHES HAUSHALTSGERÄT**
OPERATING DEVICE, IN PARTICULAR FOR AN ELECTRONIC HOUSEHOLD APPLIANCE
DISPOSITIF DE COMMANDE, NOTAMMENT POUR APPAREIL DOMESTIQUE ÉLECTRONIQUE

(43) Veröffentlichungstag der Anmeldung: 03.01.2018
(73) Patentinhaber: Diehl AKO Stiftung & Co. KG, 88239 Wangen (DE)
(72) Erfinder: LYSZUS, Joachim, 88255 Baindt (DE); FUHGE, Bruno, 88147 Achberg (DE)
(74) Vertreter: Diehl Patentabteilung
(86) Internationale Anmeldenummer: PCT/EP2015/000447
(87) Internationale Veröffentlichungsnummer: WO 2016/134737

(56) Entgegenhaltungen:
- EP-A1- 2 053 745
- WO-A2-2010/022920
- WO-A2-2012/166710
- DE-A1-102008 052 816
- DE-A1-102013 003 659
- US-A1- 2014 340 353
- US-A1- 2015 008 943

## Beschreibung

Die vorliegende Erfindung betrifft eine Bedienvorrichtung, insbesondere eine Bedienvorrichtung für elektronische Haushaltsgeräte.

Für Bedienvorrichtungen sind verschiedene Arten von Bedienelementen mit unterschiedlichen Funktionsweisen bekannt. Bei den als Drucktasten ausgebildeten Bedienelementen kann man zum Beispiel zwischen berührungs- und/oder annäherungsempfindlichen Drucktasten (sog. "Touch Control") und durch Krafteinwirkung betätigbaren Drucktasten differenzieren, die jeweils mit verschiedenen Aufbauten und Funktionsweisen realisierbar sind.

In diesem Zusammenhang sind bei den durch Krafteinwirkung betätigbaren Drucktasten neben solchen mit einem mechanischen Betätigungselement insbesondere auch kapazitive Drucktasten (vgl. z.B. DE 10 2011 121 897 A1), induktive Drucktasten (vgl. z.B. EP 2 529 484 B1) und piezoelektrische Drucktasten (vgl. z.B. EP 2 063 533 B1) bekannt. Diese speziellen Drucktasten erfordern im Allgemeinen eine hohe Fertigungs- und Montagegenauigkeit mit kleinen Toleranzbereichen. Darüber hinaus werden in letzter Zeit auch Drucktasten mit optischen Sensorsystemen entwickelt.

Ferner offenbart die WO 2012/166710 A2 eine Bedienvorrichtung. Diese herkömmliche Bedienvorrichtung enthält einen induktiven oder kapazitiven Sensor, der eine Abstandsänderung zu einer Metallplatte an einem bewegbaren Knopf erfassen kann, wobei der Knopf bei einer Druckbetätigung eines Bedienabschnitts der Abdeckplatte aufgrund der Verformung des Bedienabschnitts in Richtung zum Sensor bewegt wird. Außerdem weist diese herkömmliche Bedienvorrichtung zwischen der Abdeckplatte und der Leiterplatte ein Abstandselement auf, das im Fall eines optional vorhandenen Lichtleitelements zwischen Abdeckplatte und Leiterplatte neben einer Öffnung für den bewegbaren Knopf auch eine Öffnung zum Aufnehmen eines Fingers des Lichtleitelements im Bereich des Bedienabschnitts aufweist.

Ferner offenbart auch die WO 2010/022920 A2 eine Bedienvorrichtung.

Bei dieser herkömmlichen Bedienvorrichtung ist eine lichtleitende Struktur hinter einer Abdeckplatte mit einer Lichtquelle und einem optischen Empfänger gekoppelt und sind zwischen der lichtleitenden Struktur und einem drucksensitiven Tastenbereich der Abdeckplatte eine elastische Auflage und ein Mittel zum Toleranzausgleich angeordnet. Bei Druckausübung auf den Tastenbereich der Abdeckplatte drückt diese über das Toleranzausgleichsmittel und die elastische Auflage gegen die lichtleitende Struktur, sodass ein sich in der lichtleitenden Struktur ausbreitendes Licht gestört wird und diese Störung als Tastsignal ausgewertet werden kann.

Es ist die Aufgabe der vorliegenden Erfindung, eine verbesserte Bedienvorrichtung mit einer durch Krafteinwirkung betätigbaren Drucktaste zu schaffen.

Diese Aufgabe wird gelöst durch eine Bedienvorrichtung mit den Merkmalen des Anspruchs 1. Besonders bevorzugte Ausgestaltungen und Weiterbildungen der Erfindung sind Gegenstand der abhängigen Ansprüche.

Die Bedienvorrichtung der Erfindung weist auf: eine Abdeckplatte mit einer einem Benutzer zugewandten Benutzerseite und einer dem Benutzer abgewandten Innenseite, wobei die Abdeckplatte einen Bedienabschnitt definiert und in diesem Bedienabschnitt zumindest teilweise elastisch verformbar und/oder bewegbar ausgestaltet ist; eine Trägerplatte, die auf einer der Benutzerseite abgewandten Seite der Abdeckplatte zu dieser beabstandet angeordnet ist; einen Sensor, der auf der Trägerplatte vorgesehen und derart ausgestaltet und angeordnet ist, dass er eine Abstandsänderung zur Innenseite der Abdeckplatte im Bereich des Bedienabschnitts der Abdeckplatte erfassen kann; und ein formstabiles Lichtleitelement, das sich in einem Bereich außerhalb des Bedienabschnitts der Abdeckplatte von der Abdeckplatte bis zur Trägerplatte erstreckt sowie einerseits gegen die Trägerplatte und andererseits gegen die Abdeckplatte abstützt, wobei die Abdeckplatte im Bereich des Lichtleitelements einen Signalabschnitt aufweist, der zumindest teilweise lichtdurchlässig ausgebildet ist.

Die erfindungsgemäße Bedienvorrichtung weist einen Signalabschnitt in der Nähe des Bedienabschnitts auf, mit dem der Bedienabschnitt für den Benutzer optisch gekennzeichnet werden kann. Über den Signalabschnitt besteht vorzugsweise auch die Möglichkeit, nicht nur den Bedienabschnitt zu kennzeichnen, sondern dem Benutzer auch weitere Informationen zum Beispiel über den Betriebszustand des Bedienabschnitts oder des Haushaltsgeräts mitzuteilen.

Bei der erfindungsgemäßen Bedienvorrichtung erstreckt sich ein formstabiles Lichtleitelement in einem Bereich außerhalb des Bedienabschnitts der Abdeckplatte von der Abdeckplatte bis zur Trägerplatte. Das Lichtleitelement ist mit dem Signalabschnitt der Abdeckplatte gekoppelt und unterstützt damit die optische Kennzeichnung des Bedienabschnitts der Bedienvorrichtung. Außerdem stützt sich das formstabile Lichtleitelement einerseits gegen die Trägerplatte und andererseits gegen die Abdeckplatte ab, sodass es auch die Funktion einer mechanischen Stütze ausübt. Der Bereich außerhalb des Bedienabschnitts, der sich bei Krafteinwirkung verformen oder bewegen kann, wird so durch das Lichtleitelement mechanisch stabilisiert. Der Bedienabschnitt der Abdeckplatte kann so zuverlässiger von den anderen Bereichen der Abdeckplatte mechanisch entkoppelt werden, sodass eine Betätigung des Bedienabschnitts durch einen Benutzer durch den Sensor zuverlässiger detektiert werden kann.

Die Abdeckplatte kann in diesem Zusammenhang grundsätzlich aus einem beliebigen Material (z.B. transparent oder lichtundurchlässig, elektrisch leitfähig oder elektrisch nicht leitend, etc.), mit beliebigen Dimensionierungen und mit einem beliebigen Design gefertigt sein. Die erfindungsgemäße Bedienvorrichtung ist aber insbesondere auch für die Anwendung bei metallischen Abdeckplatten geeignet. Bei der Abdeckplatte handelt es sich vorzugsweise um eine Bedienblende zum Beispiel eines elektronischen Haushaltsgeräts.

Der Bedienabschnitt ist vorzugsweise einstückig mit der Abdeckplatte ausgebildet, als separate Komponente in die Abdeckplatte eingesetzt oder als separate Komponente fest mit der Abdeckplatte verbunden. Der Bedienabschnitt definiert für den Benutzer ein Bedienelement der Bedienvorrichtung, das er zum Betätigen drücken muss. D.h. der Bedienabschnitt bildet eine durch Krafteinwirkung betätigbare Drucktaste. Der Bedienabschnitt kann vorzugsweise zusätzlich für den Benutzer kenntlich gemacht sein, bevorzugt durch eine spezielle Formgebung seiner Benutzerseite (haptische Kennzeichnung), eine Kennzeichnung mit Farben und/oder Symbolen und dergleichen.

Der Bedienabschnitt ist durch eine Krafteinwirkung von der Benutzerseite der Abdeckplatte her zumindest teilweise elastisch verformbar und/oder bewegbar. Die elastische Verformbarkeit wird vorzugsweise durch eine spezielle Materialwahl und/oder eine spezielle Dimensionierung (insbes. in Dickenrichtung) des Bedienabschnitts erzielt. Die elastische Bewegbarkeit kann vorzugsweise durch eine gefederte Lagerung des Bedienabschnitts in einer Durchbrechung in der Abdeckplatte realisiert werden.

Die Trägerplatte ist vorzugsweise als eine Leiterplatte ausgestaltet. Der Sensor ist auf einer der Abdeckplatte zugewandten Seite der Trägerplatte und/oder auf einer der Abdeckplatte abgewandten Seite der Trägerplatte angeordnet. Die Trägerplatte ist vorzugsweise im Wesentlichen parallel zur Abdeckplatte angeordnet. Auf der Trägerplatte ist zudem vorzugsweise eine Steuereinrichtung zum Ansteuern des Sensors und Aufnehmen der Messsignale des Sensors angeordnet.

Das Lichtleitelement zwischen der Abdeckplatte und der Trägerplatte ist formstabil ausgebildet. Der Begriff Formstabilität bezieht sich in diesem Zusammenhang auf eine stabil gleichbleibende Form und Dimension des Lichtleitelements bei einer bestimmungsgemäßen Verwendung der Bedienvorrichtung, d.h. insbesondere bei bestimmungsgemäßen Krafteinwirkungen (z.B. für eine Betätigung der Drucktasten) und bestimmungsgemäßen Temperaturbereichen. Durch die Formstabilität des Lichtleitelements kann eine Verformung bzw. Bewegung der Abdeckplatte in einem Bereich außerhalb des Bedienabschnitts - unabhängig von der Ausgestaltung der Abdeckplatte in jenem Bereichen - unterdrückt oder zumindest stark eingeschränkt werden. So können die Drucktastenfunktionalität auf den Bedienabschnitt begrenzt und ein "Übersprechen" mit z.B. anderen Bedienabschnitten der Abdeckplatte verhindert werden.

Das Lichtleitelement ist derart ausgestaltet, dass es Licht, insbesondere Licht im sichtbaren Wellenlängenbereich, von einer Einkoppelfläche des Lichtleitelements zu einer Auskoppelfläche des Lichtleitelements mit möglichst wenig (Intensitäts-) Verlust leitet. Die Einkoppelfläche des Lichtleitelements ist vorzugsweise mit wenigstens einer Lichtquelle, bevorzugt in Form einer Leuchtdiode, auf der Trägerplatte gekoppelt. Die Auskoppelfläche des Lichtleitelements ist mit dem Signalabschnitt bzw. dessen lichtdurchlässigen Teilbereichen gekoppelt. Das Lichtleitelement ist vorzugsweise aus einem Kunststoffmaterial gefertigt. Die Bedienvorrichtung kann vorzugsweise ein oder mehrere Lichtleitelemente aufweisen.

Der Signalabschnitt der Abdeckplatte soll den Bedienabschnitt der Abdeckplatte für den Benutzer optisch kennzeichnen. In einer Ausgestaltung umgibt der Signalabschnitt den Bedienabschnitt im Wesentlichen vollumfänglich oder zumindest in Teilabschnitten. In anderen Ausgestaltungen stellt der Signalabschnitt ein Symbol oder ein 7-Segment-Display dar.

Die Bedienvorrichtung der Erfindung kann neben der durch Krafteinwirkung betätigbaren Drucktaste, deren Betätigung durch den Sensor erfasst wird, optional weitere Bedienelemente mit anderen Funktionsweisen enthalten. Dabei können insbesondere berührungs- und/oder annäherungsempfindliche Tasten zum Einsatz kommen.

In einer bevorzugten Ausgestaltung der Erfindung ist der Sensor ein optischer Sensor. Der optische Sensor weist vorzugsweise wenigstens einen Sender zum Emittieren elektromagnetischer Strahlung und wenigstens einen Empfänger zum Erfassen der elektromagnetischen Strahlung auf. Der Sensor verwendet dabei vorzugsweise eine elektromagnetische Strahlung in einem anderen Wellenlängenbereich, bevorzugt im Infrarotbereich, als das Lichtleitelement. Bei dieser Ausgestaltung ist außerdem das Lichtleitelement vorzugsweise so ausgebildet, dass es die vom Sensor verwendete elektromagnetische Strahlung absorbiert, bevorzugt nahezu vollständig absorbiert. Auf diese Weise kann verhindert werden, dass das Licht zum Kennzeichnen des Bedienabschnitts die Messwerte des Sensors beeinflusst. Bei der erfindungsgemäßen Bedienvorrichtung mit optischem Sensor genügen minimale Verformungen bzw. Bewegungshübe des Bedienabschnitts, um eine Betätigung durch den Benutzer erfassen zu können, da bereits sehr kleine Veränderungen der Reflexionsorte am Bedienabschnitt sehr unterschiedliche Ablenkungen der elektromagnetischen Strahlung bewirken. Die Betätigung des Bedienabschnitts kann daher sehr zuverlässig erkannt werden. Zudem dürfen bei dieser Konstruktion die Toleranzen bei Fertigung und Montage der Bauteile im Vergleich zu herkömmlichen, durch Krafteinwirkung betätigbaren Drucktasten mit kapazitiver, induktiver oder piezoelektrischer Funktionsweise größer sein. Da es für die Detektion einer Betätigung des Bedienabschnitts ausreicht, eine relative Veränderung des Erfassungsortes der reflektierten Strahlung zu erfassen, kann bei einer so aufgebauten Bedienvorrichtung auch ein Kalibriervorgang entfallen.

Bei der Verwendung eines optischen Sensors ist die Innenseite der Abdeckplatte im Bereich des Bedienabschnitts vorzugsweise mit einer Reflexionsfläche ausgebildet. Die Reflexionsfläche des Bedienabschnitts ist bevorzugt so ausgestaltet, dass sie die von dem Sender emittierte Strahlung zumindest teilweise reflektieren kann. Diese Reflexionseigenschaft wird vorzugsweise erreicht durch eine spezielle Materialauswahl, eine spezielle Oberflächenstruktur, eine spezielle Oberflächenbehandlung (bevorzugt Beschichtung, etc.) der Innenseite der Abdeckplatte oder dergleichen. Die Reflexionsfläche ist vorzugsweise nur im Bereich des Bedienabschnitts vorgesehen, kann alternativ aber auch über die gesamte Abdeckplatte hinweg ausgebildet sein.

Bei dem Sender des Sensors handelt es sich vorzugsweise um Leuchtdioden, Laserdioden, Glühlampen, Halogenlampen oder dergleichen. Der Empfänger ermöglicht vorzugsweise eine ortsaufgelöste Erfassung der reflektierten Strahlung. Der Empfänger ist dementsprechend bevorzugt ausgewählt aus CCD-Chips, aktiven Pixelsensoren, Photodioden, Phototransistoren, etc. und Anordnungen solcher Elemente.

In einer weiteren bevorzugten Ausgestaltung der Erfindung ist zwischen dem Sensor und der Abdeckplatte ein Linsenelement angeordnet. Dieses Linsenelement soll vorzugsweise die Leistungsfähigkeit und die Funktionssicherheit des Sensors verbessern. Bei dieser Ausgestaltung ist das Linsenelement bevorzugt integral mit dem Lichtleitelement ausgebildet, d.h. bevorzugt einstückig mit diesem ausgebildet oder an dieses angeformt.

In einer weiteren bevorzugten Ausgestaltung der Erfindung weist der Sensor ein Sensorgehäuse auf. Das Sensorgehäuse kann vorzugsweise Aussparungen zum Aufnehmen von Sender und Empfänger des Sensors aufweisen. Das Sensorgehäuse ist vorzugsweise platten- oder rahmenförmig ausgestaltet. Das Sensorgehäuse kann vorzugsweise der optischen Trennung zwischen Sender und Empfänger und/oder dem mechanischen Schutz der Sensorkomponenten dienen. Bei dieser Ausgestaltung ist das Sensorgehäuse vorzugsweise integral mit dem Lichtleitelement ausgebildet, d.h. bevorzugt einstückig mit diesem ausgestaltet oder an dieses angeformt.

In einer bevorzugten Ausgestaltung der Erfindung weist der Signalabschnitt der Abdeckplatte wenigstens eine Durchbrechung auf. Diese Ausgestaltung ist insbesondere für Abdeckplatten aus einem lichtundurchlässigen Material von Vorteil. Die wenigstens eine Durchbrechung des Signalabschnitts ist vorzugsweise mit einer lichtdurchlässigen Vergussmasse, zum Beispiel aus einem transparenten Klebstoff oder Kunstharz, verschlossen.

In einer bevorzugten Ausgestaltung der Erfindung weist das Lichtleitelement erste Rasteinrichtungen (z.B. Rasthaken) auf, die mit zweiten Rasteinrichtungen (z.B. Haken oder Löcher) an der Trägerplatte in Eingriff stehen.

In einer weiteren bevorzugten Ausgestaltung der Erfindung ist das Lichtleitelement mit der Abdeckplatte verklebt.

In einer noch weiteren bevorzugten Ausgestaltung der Erfindung definiert die Abdeckplatte mehrere, voneinander getrennte Bedienabschnitte nebeneinander, sind mehrere Sensoren entsprechend den mehreren Bedienabschnitten nebeneinander auf der Trägerplatte angeordnet, und sind in Bereichen zwischen den mehreren Bedienabschnitten jeweils formstabile Lichtleitelemente vorgesehen. Durch die Verwendung der formstabilen Lichtleitelemente kann der Abstand zwischen benachbarten Bedienabschnitten relativ klein gewählt werden, ohne dass die Gefahr eines Übersprechens zwischen den benachbarten Drucktasten entsteht. Auf diese Weise können sogar Bedienvorrichtungen in der Art eines Sliders realisiert werden.

Gegenstand der Erfindung ist auch ein elektronisches Haushaltsgerät mit wenigstens einer oben beschriebenen Bedienvorrichtung der Erfindung.

Bei dem elektronischen Haushaltsgerät handelt es sich vorzugsweise um ein Wäschebehandlungsgerät (Waschmaschine, Wäschetrockner, etc.), eine Spülmaschine, ein Kühl- und/oder Gefriergerät, ein Kochfeld, einen Herd, einen Mikrowellenofen, eine Dunstabzugshaube oder dergleichen.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine perspektivische Schnittansicht einer Bedienvorrichtung gemäß einem ersten Ausführungsbeispiel der Erfindung;
- Fig. 2: eine starke vereinfachte Darstellung des Funktionsprinzips der Bedienvorrichtung gemäß einer bevorzugten Ausführungsvariante, wobei Teilfigur 2A den nicht betätigten Funktionszustand zeigt und Teilfigur 2B den betätigten Funktionszustand zeigt;
- Fig. 3: eine Perspektivansicht einer Bedienvorrichtung der Bedienvorrichtung zum Erläutern des Zusammenbaus der Bedienvorrichtung;
- Fig. 4: eine perspektivische Schnittansicht einer Bedienvorrichtung gemäß einem zweiten Ausführungsbeispiel der Erfindung; und
- Fig. 5: eine Teilperspektivansicht einer Bedienvorrichtung gemäß einem dritten Ausführungsbeispiel der Erfindung.

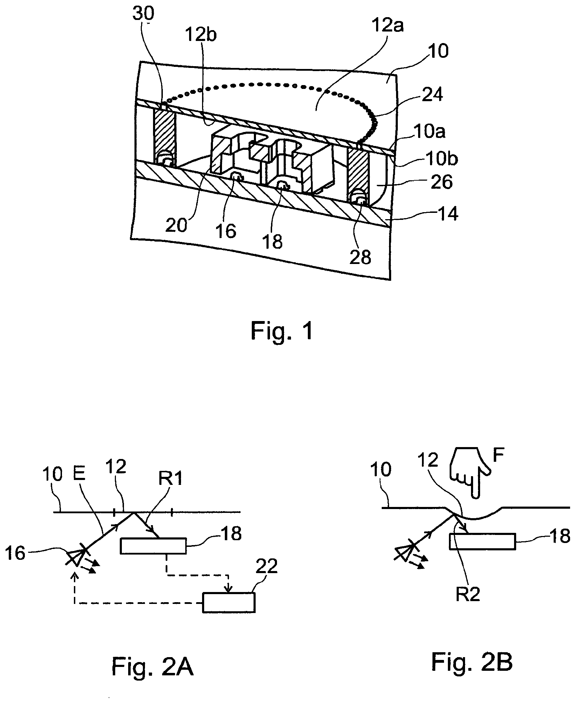

Bezug nehmend auf Fig. 1 und 2 wird nun ein erstes Ausführungsbeispiel einer erfindungsgemäß ausgestalteten Bedienvorrichtung näher erläutert.

Die Bedienvorrichtung weist eine Abdeckplatte 10 in Form einer Bedienblende auf. Die Abdeckplatte 10 ist beispielsweise aus Metall (z.B. Edelstahlblech) oder einem opaken Kunststoffmaterial gefertigt. Die Abdeckplatte 10 hat eine dem Benutzer zugewandte Benutzerseite 10a (oben in Fig. 1), welche der Außenseite der Bedienblende entspricht, und eine dem Benutzer abgewandte Innenseite 10b (unten in Fig. 1).

Die Abdeckplatte 10 weist einen Bedienabschnitt 12a auf, der für den Benutzer ein Bedienelement definiert, das er betätigen kann. Der Bedienabschnitt 12a ist in die Abdeckplatte 10 integriert bzw. einteilig mit dieser ausgebildet oder als separate Komponente in diese eingesetzt und wahlweise mit dieser verbunden. Wie ein Vergleich der Teilfiguren 2A und 2B zeigt, ist der Bedienabschnitt 12a durch eine Krafteinwirkung F von der Benutzerseite 10a her, zum Beispiel mit einem Finger des Benutzers, elastisch verformbar oder bewegbar ausgestaltet. D.h. nach Beendigung der Krafteinwirkung F kehrt der Bedienabschnitt 12a wieder in seinen Ausgangszustand von Fig. 1 bzw. 2A zurück.

Die Bedienvorrichtung weist ferner eine Trägerplatte 14 in Form einer Leiterplatte auf. Diese Trägerplatte 14 ist im Wesentlichen parallel zur Abdeckplatte 10 ausgerichtet und auf der der Benutzerseite 10a abgewandten Seite der Abdeckplatte 10 beabstandet zu dieser angeordnet. Auf dieser Trägerplatte 14 ist - in diesem Ausführungsbeispiel auf ihrer der Abdeckplatte 10 zugewandten Seite - an einer dem Bedienabschnitt 12a entsprechenden Position ein Sensor angeordnet.

In diesem Ausführungsbeispiel ist der Sensor als ein optischer Sensor ausgebildet, der einen Sender 16 zum Beispiel in Form einer Leuchtdiode und einen Empfänger 18 zum Beispiel in Form eines CCD-Chips aufweist. Der Sender 16 emittiert elektromagnetische Strahlung, vorzugsweise im sichtbaren oder Infrarot-Wellenlängenbereich, und der Empfänger 18 erfasst elektromagnetische Strahlung desselben Wellenlängenbereichs.

Wie in Fig. 2 veranschaulicht, trifft die vom Sender 16 emittierte Strahlung E auf die Innenseite 10b der Abdeckplatte 10, die im Bereich des Bedienabschnitts 12a mit einer Reflexionsfläche 12b versehen ist. So wird die Strahlung E am Bedienabschnitt 12 reflektiert und die reflektierte Strahlung R1, R2 trifft dann auf den Empfänger 18 und wird von diesem erfasst. Der Empfänger 18 ist so ausgestaltet, dass er die elektromagnetische Strahlung ortsaufgelöst erfassen kann. Im Ausgangszustand von Teilfigur 2A, d.h. ohne Betätigung des Bedienabschnitts 12a durch den Benutzer, befindet sich der Bedienabschnitt 12a in seinem unverformten Ausgangszustand und die Reflexionsfläche 12b reflektiert die Strahlung R1 zum Empfänger 18. Im Betätigungszustand von Teilfigur 2B, d.h. bei einer Krafteinwirkung F durch den Benutzer auf den Bedienabschnitt 12a, ist der Bedienabschnitt 12a verformt und die Reflexionsfläche 12b reflektiert die Strahlung R2 zum Empfänger 18. Der Vergleich der Teilfiguren 2A und 2B zeigt, dass selbst bei einer geringen Verformung des Bedienabschnitts 12a bereits eine sehr deutliche Veränderung des Erfassungsortes der reflektierten Strahlung R2 erfolgt. Diese relative Veränderung des Erfassungsortes wird von dem ortsauflösenden Empfänger 18 erfasst. Die mit dem Sender 16 und dem Empfänger 18 leitungsgebunden oder drahtlos verbundene Steuereinrichtung 22, die zum Beispiel ebenfalls auf der Trägerplatte 14 angeordnet sein kann, steuert den Sender 16 an und wertet die vom Empfänger 18 erzeugten Messsignale aus.

Wie in Fig. 1 dargestellt, weist der Sensor auch ein Sensorgehäuse 20 auf, das im Wesentlichen platten- oder rahmenförmig ausgestaltet und auf der Trägerplatte 14 montiert ist. Das Sensorgehäuse 20 weist Aussparungen zum Aufnehmen des Senders 16 und des Empfängers 18 auf, die durch eine Trennwand voneinander getrennt sind. Das Sensorgehäuse 20 ist vorzugsweise aus einem Kunststoffmaterial gefertigt. Außerdem ist das Sensorgehäuse 20 bevorzugt für die von dem Sensoren benutzte elektromagnetische Strahlung im Wesentlichen absorbierend oder undurchlässig ausgebildet, um eine direkte optische Verbindung zwischen Sender 16 und Empfänger 18 zu verhindern.

Der im Wesentlichen kreisförmige Bedienabschnitt 12a der Abdeckplatte 10 ist von einem im Wesentlichen ringförmigen Signalabschnitt 24 umgeben. Dieser Signalabschnitt 24 weist zahlreiche Durchbrechungen 30 auf und ist damit lichtdurchlässig ausgebildet. Mit diesem Signalabschnitt 24 kann der Bedienabschnitt 12a für den Benutzer optisch gekennzeichnet werden. Außerdem kann dem Benutzer mit Hilfe des Signalabschnitts 24 zum Beispiel der Betriebszustand der Bedienvorrichtung angezeigt werden.

Auf der Innenseite 10b der Abdeckplatte 10 ist dem Signalabschnitt 24 ein formstabiles Lichtleitelement 26 zugeordnet. Das Lichtleitelement 26 ist dementsprechend ebenfalls außerhalb des Bedienabschnitts 12a angeordnet und im Wesentlichen ringförmig ausgebildet. Das Lichtleitelement 26 erstreckt sich von der Abdeckplatte 10 bzw. deren Innenseite 10b bis zur Trägerplatte 14. Mit anderen Worten stützt sich das Lichtleitelement 26 einerseits gegen die Abdeckplatte 10 und andererseits gegen die Trägerplatte 14 ab. Aufgrund der Formstabilität des Lichtleitelements 26 wird eine Verformung oder Bewegung der Abdeckplatte 10 im Bereich außerhalb des Bedienabschnitts 12a unterdrückt.

Das Lichtleitelement 26 ist vorzugsweise aus einem Kunststoffmaterial gefertigt und zum Leiten elektromagnetischer Strahlung im sichtbaren Wellenlängenbereich ausgelegt. Die der Trägerplatte 14 zugewandte Einkoppelfläche des Lichtleitelements 26 ist mit einer oder mehreren Lichtquellen 28 gekoppelt, die beispielsweise durch Leuchtdioden auf der Trägerplatte 14 realisiert sind. Die der Abdeckplatte 10 zugewandte Auskoppelfläche des Lichtleitelements 26 ist mit dem Signalabschnitt 24 bzw. dessen Durchbrechungen 30 gekoppelt.

Die Durchbrechungen 30 des Signalabschnitts 24 der Abdeckplatte 10 sind bevorzugt mit einem transparenten Klebstoff oder Kunstharz vergossen. Diese Vergussmasse kann zugleich als Klebeverbindung zwischen der Abdeckplatte 10 und dem Lichtleitelement 26 dienen; alternativ kann eine zusätzliche transparente Klebstoffschicht vorgesehen sein, um die nötige Haltekraft aufzubringen.

Das Lichtleitelement 26 ist bevorzugt so ausgestaltet, dass es die vom Sensor benutzte elektromagnetische Strahlung vorzugsweise vollständig absorbiert. Außerdem wird für die Lichtquellen 28 bevorzugt ein anderer Wellenlängenbereich als für den Sensor verwendet. Auf diese Weise kann verhindert werden, dass das Lichtleitelement 26 die Funktionsweise des Sensors beeinträchtigt; stattdessen kann das Lichtleitelement 26 als Abschirmung des Sensors dienen.

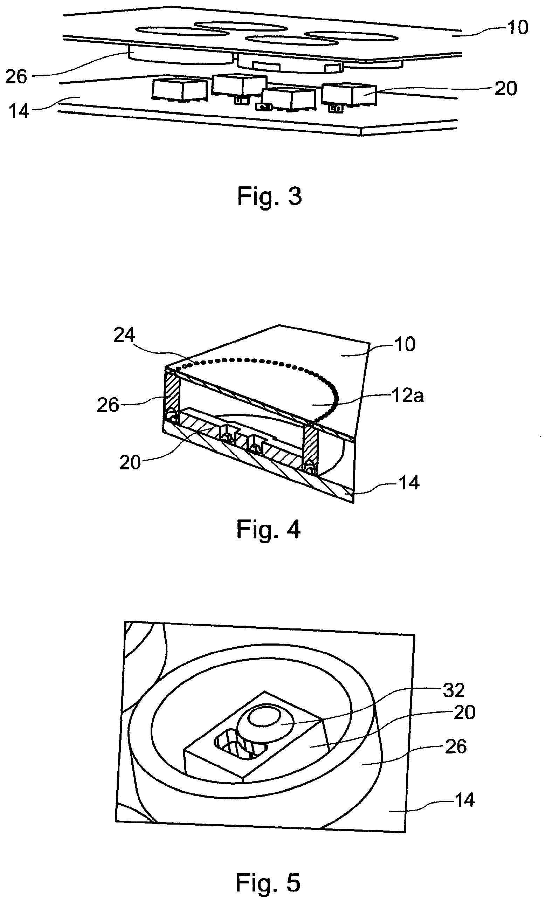

Bei der Herstellung der Bedienvorrichtung wird zunächst das Lichtleitelement 26 mit der Innenseite 10b der Abdeckplatte 10 verklebt, wie in Fig. 3 dargestellt. Andererseits werden die Sensoren 16-20 und die Lichtquellen 28 auf der Trägerplatte 14 montiert. So können eine technische Baueinheit und eine Design-Baueinheit separat vorbereitet und ggf. getestet und dann zusammengefügt werden.

Das Lichtleitelement 26 ist zum Beispiel mit Rastnasen (nicht dargestellt) als erste Rasteinrichtungen versehen, die zum Beispiel mit Löchern (nicht dargestellt) als zweite Rasteinrichtungen in der Trägerplatte 14 in Eingriff gelangen können. So kann die Trägerplatte 14 mit der darauf montierten Elektronik auf das Lichtleitelement 26 an der Abdeckplatte 10 aufgeschnappt werden. Anstelle der Rastverbindung sind beispielsweise auch Klemm- oder Schraubverbindungen denkbar.

Fig. 4 zeigt ein zweites Ausführungsbeispiel einer erfindungsgemäßen Bedienvorrichtung. Gleiche oder entsprechende Komponenten sind mit den gleichen Bezugsziffern wie im ersten Ausführungsbeispiel versehen.

Im Ausführungsbeispiel von Fig. 4 sind das Sensorgehäuse 20 des Sensors und das Lichtleitelement 26 integral miteinander ausgebildet. So können die beiden Komponenten 20, 26 beispielsweise einstückig miteinander gefertigt werden oder kann die eine Komponente an die andere Komponente angespritzt werden. Falls die beiden Komponenten aus unterschiedlichen Kunststoffmaterialien gefertigt werden sollen, kommen hierfür zum Beispiel 2K-Spritzverfahren in Frage.

Durch die Verringerung der Anzahl an separaten Bauteilen kann bei diesem Ausführungsbeispiel der Montageprozess vereinfacht werden.

Fig. 5 zeigt ein drittes Ausführungsbeispiel einer erfindungsgemäßen Bedienvorrichtung. Gleiche oder entsprechende Komponenten sind mit den gleichen Bezugsziffern wie im ersten Ausführungsbeispiel versehen.

Bei diesem Ausführungsbeispiel ist zwischen dem Sensorgehäuse 20 und der Abdeckplatte 10 zusätzlich ein Linsenelement 32 vorgesehen.

Dieses Linsenelement 32 kann vorzugsweise integral mit dem Lichtleitelement 26 und/oder dem Sensorgehäuse 20 ausgebildet sein. Insbesondere können die Komponenten 20, 26, 32 beispielsweise einstückig miteinander gefertigt werden oder kann die eine Komponente an die andere(n) Komponente(n) angespritzt werden. Falls die Komponenten aus unterschiedlichen Kunststoffmaterialien gefertigt werden sollen, kommen hierfür zum Beispiel 2K-Spritzverfahren in Frage.

Durch die Verringerung der Anzahl an separaten Bauteilen kann bei diesem Ausführungsbeispiel der Montageprozess vereinfacht werden.

Mit der erfindungsgemäßen Bedienvorrichtung ist es insbesondere aufgrund des formstabilen Lichtleitelements 26 als mechanische Stütze möglich, mehrere Drucktasten eng nebeneinander anzuordnen. So ist als weiteres Ausführungsbeispiel der Erfindung auch die Realisierung eines Sliders mit mehreren Drucktasten nebeneinander möglich.

### BEZUGSZIFFERNLISTE

- 10: Abdeckplatte
- 10a: Benutzerseite
- 10b: Innenseite
- 12a: Bedienabschnitt
- 12b: Reflexionsfläche
- 14: Trägerplatte
- 16: Sender eines Sensors
- 18: Empfänger eines Sensors
- 20: Sensorgehäuse
- 22: Steuereinrichtung
- 24: Signalabschnitt
- 26: Lichtleitelement
- 28: Lichtquelle
- 30: Durchbrechungen
- 32: Linsenelement
- E: emittierte Strahlung
- F: Krafteinwirkung
- R1: reflektierte Strahlung
- R2: reflektierte Strahlung

## Patentansprüche

1. Bedienvorrichtung, insbesondere für ein elektronisches Haushaltsgerät, aufweisend:
eine Abdeckplatte (10) mit einer einem Benutzer zugewandten Benutzerseite (10a) und einer dem Benutzer abgewandten Innenseite (10b), wobei die Abdeckplatte (10) einen Bedienabschnitt (12a) definiert und in diesem Bedienabschnitt (12a) zumindest teilweise elastisch verformbar und/oder bewegbar ausgestaltet ist;
eine Trägerplatte (14), die auf einer der Benutzerseite (10a) abgewandten Seite der Abdeckplatte (10) zu dieser beabstandet angeordnet ist;
einen Sensor (16-20), der auf der Trägerplatte (14) vorgesehen und derart ausgestaltet und angeordnet ist, dass er eine Abstandsänderung zur Innenseite (10b) der Abdeckplatte (10) im Bereich des Bedienabschnitts (12a) der Abdeckplatte (10) erfassen kann; und
ein formstabiles Lichtleitelement (26), das sich in einem Bereich außerhalb des Bedienabschnitts (12a) der Abdeckplatte (10) von der Abdeckplatte (10) bis zur Trägerplatte (14) erstreckt sowie einerseits gegen die Trägerplatte (14) und andererseits gegen die Abdeckplatte (10) abstützt, wobei die Abdeckplatte (10) im Bereich des Lichtleitelements (26) einen Signalabschnitt (24) aufweist, der zumindest teilweise lichtdurchlässig ausgebildet ist.

2. Bedienvorrichtung nach Anspruch 1, bei welcher
der Sensor (16-20) ein optischer Sensor ist; und
das Lichtleitelement (26) eine vom Sensor (16-20) verwendete elektromagnetische Strahlung absorbierend ausgebildet ist.

3. Bedienvorrichtung nach Anspruch 2, bei welcher
zwischen dem Sensor (16-20) und der Abdeckplatte (10) ein Linsenelement (32) angeordnet ist; und
das Linsenelement (32) integral mit dem Lichtleitelement (26) ausgebildet ist.

4. Bedienvorrichtung nach einem der vorhergehenden Ansprüche, bei welcher
der Sensor (16-20) ein Sensorgehäuse (20) aufweist, welches integral mit dem Lichtleitelement (26) ausgebildet ist.

5. Bedienvorrichtung nach einem der vorhergehenden Ansprüche, bei welcher
der Signalabschnitt (24) der Abdeckplatte (10) wenigstens eine Durchbrechung (30) aufweist; und
die wenigstens eine Durchbrechung (30) des Signalabschnitts (24) mit einer lichtdurchlässigen Vergussmasse verschlossen ist.

6. Bedienvorrichtung nach einem der vorhergehenden Ansprüche, bei welcher
das Lichtleitelement (26) erste Rasteinrichtungen aufweist, die mit zweiten Rasteinrichtungen an der Trägerplatte (14) in Eingriff stehen.

7. Bedienvorrichtung nach einem der vorhergehenden Ansprüche, bei welcher das Lichtleitelement (26) mit der Abdeckplatte (10) verklebt ist.

8. Bedienvorrichtung nach einem der vorhergehenden Ansprüche, bei welcher
der Sensor (16-20) einen Sender (16) zum Emittieren von elektromagnetischer Strahlung (E) und einen Empfänger (18) zum Erfassen der elektromagnetischen Strahlung (R1, R2) aufweist; und
der Empfänger (18) des Sensors derart angeordnet und/oder ausgestaltet ist, dass er eine ortsaufgelöste Erfassung der von dem Sender (16) emittierten und dann reflektierten elektromagnetischen Strahlung (R1, R2) ermöglicht.

9. Bedienvorrichtung nach einem der vorhergehenden Ansprüche, bei welcher
die Abdeckplatte (10) mehrere, voneinander getrennte Bedienabschnitte (12a) nebeneinander definiert;
mehrere Sensoren (16-20) nebeneinander auf der Trägerplatte (14) angeordnet sind; und
in Bereichen zwischen den Bedienabschnitten (12a) formstabile Lichtleitelemente (26) vorgesehen sind.

10. Elektronisches Haushaltsgerät mit wenigstens einer Bedienvorrichtung nach einem der vorhergehenden Ansprüche.

## Claims

1. Operating device, in particular for an electronic household appliance, comprising:
a cover plate (10) having a user side (10a) facing toward a user, and an inner side (10b) facing away from the user, the cover plate (10) defining an operating section (12a) and being configured to be at least partially elastically deformable and/or movable in this operating section (12a);
a carrier plate (14), which is arranged on a side of the cover plate (10) facing away from the user side (10a) and at a distance from this plate;
a sensor (16-20), which is provided on the carrier plate (14) and is configured and arranged in such a way that it can detect a distance variation from the inner side (10b) of the cover plate (10) in the region of the operating section (12a) of the cover plate (10); and
a geometrically stable light guide element (26), which extends in a region outside the operating section (12a) of the cover plate (10) from the cover plate (10) to the carrier plate (14) and is supported on one side against the carrier plate (14) and on the other side against the cover plate (10), the cover plate (10) comprising a signal section (24), which is configured to be at least partially light-transmissive, in the region of the light guide element (26).

2. Operating device according to Claim 1, wherein
the sensor (16-20) is an optical sensor; and
the light guide element (26) is configured to absorb electromagnetic radiation used by the sensor (16-20).

3. Operating device according to Claim 2, wherein
a lens element (32) is arranged between the sensor (16-20) and the cover plate (10); and
the lens element (32) is formed integrally with the light guide element (26).

4. Operating device according to one of the preceding claims, wherein
the sensor (16-20) comprises a sensor housing (20), which is formed integrally with the light guide element (26).

5. Operating device according to one of the preceding claims, wherein
the signal section (24) of the cover plate (10) comprises at least one opening (30); and
the at least one opening (30) of the signal section (24) is closed with a light-transmissive casting compound.

6. Operating device according to one of the preceding claims, wherein
the light guide element (26) comprises first latching devices, which are engaged with second latching devices on the carrier plate (14).

7. Operating device according to one of the preceding claims, wherein
the light guide element (26) is adhesively bonded to the cover plate (10)

8. Operating device according to one of the preceding claims, wherein
the sensor (16-20) comprises a transmitter (16) for emitting electromagnetic radiation (E) and a receiver (18) for detecting the electromagnetic radiation (R1, R2); and
the receiver (18) of the sensor is arranged and/or configured in such a way that it allows position-resolved detection of the electromagnetic radiation (R1, R2) emitted by the transmitter (16) and then reflected.

9. Operating device according to one of the preceding claims, wherein
the cover plate (10) defines a plurality of mutually separated operating sections (12a) next to one another; a plurality of sensors (16-20) are arranged next to one another on the carrier plate (14); and
geometrically stable light guide elements (26) are provided in regions between the operating sections (12a).

10. Electronic household appliance having at least one operating device according to one of the preceding claims.

## Revendications

1. Dispositif de commande, en particulier pour un appareil ménager électronique, présentant :
une plaque de recouvrement (10) dotée d'un côté utilisateur (10a) tourné vers un utilisateur et d'un côté intérieur (10b) détourné de l'utilisateur, la plaque de recouvrement (10) définissant une partie de commande (12a) et étant configurée au moins en partie de manière élastiquement déformable et/ou mobile dans cette partie de commande (12a) ;
une plaque de support (14) qui est disposée sur, et espacée d'un côté de la plaque de recouvrement (10) détourné du côté utilisateur (10a) ;
un capteur (16 à 20) qui est prévu sur la plaque de support (14) et est configuré et disposé de telle sorte qu'il peut détecter une variation de distance par rapport au côté intérieur (10b) de la plaque de recouvrement (10) au niveau de la partie de commande (12a) de la plaque de recouvrement (10) ; et
un élément de guidage de lumière indéformable (26) qui s'étend dans une zone à l'extérieur de la partie de commande (12a) de la plaque de recouvrement (10) de la plaque de recouvrement (10) à la plaque de support (14), et qui s'appuie d'une part sur la plaque de support (14) et d'autre part sur la plaque de recouvrement (10), la plaque de recouvrement (10) présentant au niveau de l'élément de guidage de lumière (26) une partie de signal (24) qui est réalisée au moins en partie de manière transparente.

2. Dispositif de commande selon la revendication 1, dans lequel
le capteur (16 à 20) est un capteur optique ; et l'élément de guidage de lumière (26) est réalisé pour absorber un rayonnement électromagnétique utilisé par le capteur (16 à 20).

3. Dispositif de commande selon la revendication 2, dans lequel
un élément de lentille (32) est disposé entre le capteur (16 à 20) et la plaque de recouvrement (10) ; et
l'élément de lentille (32) est réalisé d'un seul tenant avec l'élément de guidage de lumière (26).

4. Dispositif de commande selon l'une quelconque des revendications précédentes, dans lequel le capteur (16 à 20) présente un boîtier de capteur (20) qui est réalisé d'un seul tenant avec l'élément de guidage de lumière (26).

5. Dispositif de commande selon l'une quelconque des revendications précédentes, dans lequel
la partie de signal (24) de la plaque de recouvrement (10) présente au moins un passage (30) ; et
ledit au moins un passage (30) de la partie de signal (24) est fermé par une masse de scellement opaque.

6. Dispositif de commande selon l'une quelconque des revendications précédentes, dans lequel l'élément de guidage de lumière (26) présente des premiers dispositifs d'arrêt qui sont en prise avec des deuxièmes dispositifs d'arrêt sur la plaque de support (14).

7. Dispositif de commande selon l'une quelconque des revendications précédentes, dans lequel l'élément de guidage de lumière (26) est collé avec la plaque de recouvrement (10).

8. Dispositif de commande selon l'une quelconque des revendications précédentes, dans lequel
le capteur (16 à 20) présente un émetteur (16) pour émettre un rayonnement électromagnétique (E) et un récepteur (18) pour détecter le rayonnement électromagnétique (R1, R2) ; et
le récepteur (18) du capteur est disposé et/ou configuré de telle sorte qu'il permet une détection à résolution spatiale du rayonnement électromagnétique (R1, R2) émis par l'émetteur (16) et ensuite réfléchi.

9. Dispositif de commande selon l'une quelconque des revendications précédentes, dans lequel
la plaque de recouvrement (10) définit côte à côte plusieurs parties de commande (12a) séparées les unes des autres ;
plusieurs capteurs (16 à 20) sont disposés côte à côte sur la plaque de support (14) ; et
des éléments de guidage de lumière indéformables (26) sont prévus dans des zones entre les parties de commande (12a).

10. Appareil ménager électronique comprenant au moins un dispositif de commande selon l'une quelconque des revendications précédentes.
